# EUROPEAN PATENT SPECIFICATION

(11) **EP 2 816 609 B1**
(45) Date of publication and mention of the grant of the patent: **16.01.2019**
(21) Application number: 14002126.2
(22) Date of filing: 20.06.2014
(51) Int. Cl.: H01L 31/0224

(54) **Solar cell**
Solarzelle
Cellule solaire

(30) Priority: 21.06.2013 KR 20130071777
(43) Date of publication of application: 24.12.2014
(73) Proprietor: LG Electronics, Inc., Seoul 150-721 (KR)
(72) Inventor: Lee, Jinhyung, 137-724 Seoul (KR); Kwag, Gyeayoung, 137-724 Seoul (KR); Kim, Jinsung, 137-724 Seoul (KR)
(74) Representative: Katérle, Axel

(56) References cited:
- JP-A- 2008 135 655
- JP-A- 2010 027 778
- JP-A- 2011 077 362
- US-A1- 2012 291 839

## Description

### BACKGROUND OF THE INVENTION

### 1. Field of the invention

The embodiments of the invention relate to a solar cell and, more specifically, to a solar cell with an improved electrode structure.

### 2. Description of the Related Art

Recently, conventional energy resources such as petroleum and coal are running out and interest in alternative energy sources replacing these resources has thus increased. Among such alternative energy sources, solar cells attract much attention as next-generation cells which convert solar energy into electrical energy.

Such a solar cell is manufactured by forming various layers and electrodes on a substrate according to designs. Adjacent solar cells are electrically connected to each other through a ribbon connected to a bus bar electrode. In this regard, a part of a finger electrode connected to the bus bar electrode, adjacent to a part to which the ribbon is adhered, may be disconnected due to an alignment error or a difference in width between the ribbon and the bus bar electrode. A movement route of carriers is removed in such a disconnected part and another movement route of carriers is thus required. For this reason, movement route of carriers is lengthened and efficiency of solar cells is thus deteriorated.

Further, JP 2008 135655 A discloses that a plurality of solar battery cells is connected by interconnectors. Each interconnector is connected which each bus-bar electrode. Also, the solar battery module has each auxiliary electrode so provided as to be separated from the connective region of each interconnector.

### SUMMARY OF THE INVENTION

Therefore, the embodiments of the invention have been made in view of the above problems, and it is an object of the embodiments of the invention to provide a solar cell to maximize efficiency.

The above object is solved by the claimed matter according to the independent claim. Advantageous embodiments are defined by the dependent claims.

. In accordance with an aspect of the embodiments of the invention, the above and other objects can be accomplished by the provision of a solar cell including a photoelectric conversion portion, and first and second electrodes connected to the photoelectric conversion portion, wherein at least one of the first and second electrodes includes a plurality of finger electrodes, and at least one bus bar electrode formed in a direction crossing the finger electrodes, wherein the bus bar electrode includes a main bus bar, and an auxiliary bus bar formed adjacent to the main bus bar such that the auxiliary bus bar is spaced from the main bus bar by a predetermined spacing area, and wherein the spacing area has a width equal to or less than a pitch of the plurality of finger electrodes, wherein a ratio of a width of the plurality of finger electrodes to a width of the auxiliary bus bar is 1:1 to 1:1.5,wherein the main bus bar comprises a plurality of main electrode portions and a plurality of openings disposed in a width direction of the main bus bar and the plurality of main electrode portions is disposed such that the plurality of openings are interposed therebetween,wherein the plurality of main electrode portions comprises:first main electrode portions disposed at both sides of the main bus bar; and a second main electrode portion disposed between the first main electrode portions, and wherein at least one of a width and a thickness of the first main electrode portion is different from that of the second main electrode portion.

### BRIEF DESCRIPTION OF THE DRAWINGS

The above and other objects, features and other advantages of the embodiments of the invention will be more clearly understood from the following detailed description taken in conjunction with the accompanying drawings, in which:
FIG. 1 is an exploded perspective view illustrating a solar cell module including a solar cell;
FIG. 2 is a schematic sectional view of the solar cell module, taken along line II-II of FIG. 1;
FIG. 3 is a partial sectional view illustrating the solar cell;
FIG. 4 is a front plan view illustrating the solar cell;
FIG. 5 is a rear plan view illustrating the solar cell;
FIG. 6 is a partial front plan view illustrating a solar cell;
FIG. 7 is a partial sectional view illustrating a solar cell according to an embodiment of the invention; and
FIG. 8 is a partial rear plan view illustrating the solar cell shown in FIG. 7.

### DETAILED DESCRIPTION OF THE EMBODIMENTS

Reference will now be made in detail to the preferred embodiments of the invention, examples of which are illustrated in the accompanying drawings. The invention is not limited to the embodiments and the embodiments may be modified into various forms.

In the drawings, parts unrelated to descriptions of the embodiments of the invention are not illustrated for clear and brief description of the embodiments of the invention, and the same reference numbers will be used throughout the specification to refer to the same or considerably similar parts. In the drawings, thicknesses or sizes are exaggerated or reduced for more clear description. In addition, the size or area of each constituent element is not limited to that illustrated in the drawings.

It will be further understood that, throughout this specification, when one element is referred to as "comprising" another element, the term "comprising" specifies the presence of another element but does not preclude the presence of another element, unless the context clearly indicates otherwise. In addition, it will be understood that when one element such as a layer, a film, a region or a plate is referred to as being "on" another element, the one element may be directly on the other element, and one or more intervening elements may also be present. In contrast, when one element such as a layer, a film, a region or a plate is referred to as being "directly on" another element, no intervening elements are present.

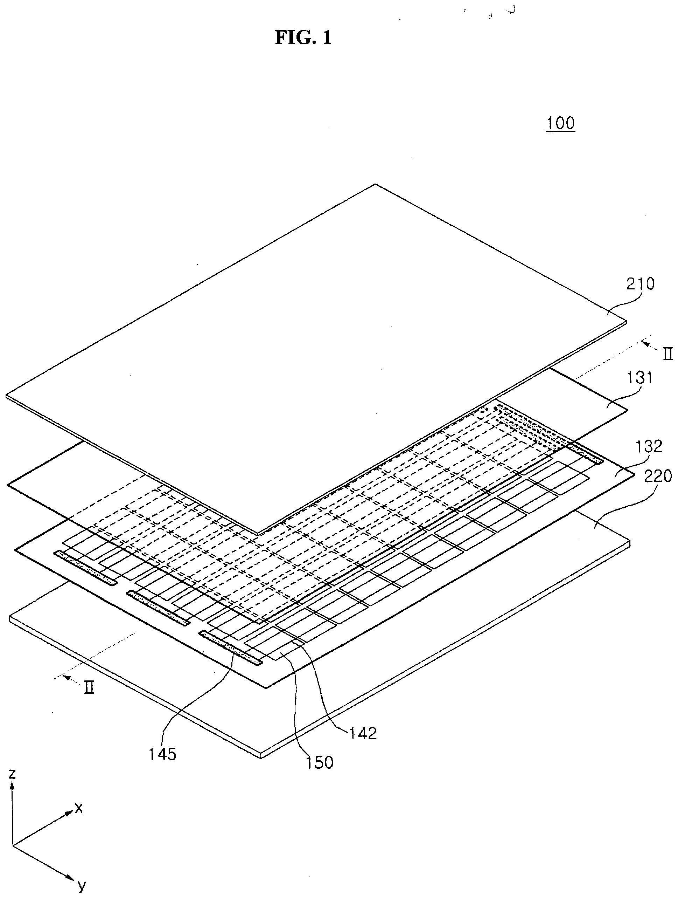

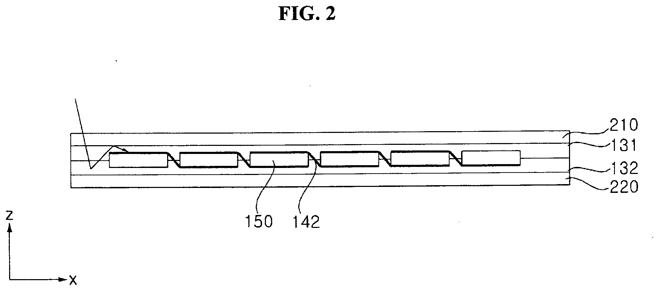

Hereinafter, FIG. 1 is an exploded perspective view illustrating a solar cell module including a solar cell and FIG. 2 is a schematic sectional view of the solar cell module, taken along line II-II of FIG. 1.

Referring to FIGS. 1 and 2, the solar cell module includes a solar cell 150, a front substrate 210 disposed on the front surface of the solar cell 150 and a rear sheet 220 disposed on the rear surface of the solar cell 150. In addition, the solar cell module 100 may include a first sealing material 131 disposed between the solar cell 150 and the front substrate 210 and a second sealing material 132 disposed between the solar cell 150 and the rear sheet 220.

First, the solar cell 150 is a semiconductor device which converts solar energy into electrical energy and may have various structures such as silicon solar cells, compound semiconductor solar cells, tandem solar cells and dye-sensitized solar cells.

Such a solar cell 150 includes a ribbon 142. Adjacent solar cells 150 may be electrically connected to each other in series, in parallel and in series-parallel through the ribbon 142. Specifically, the ribbon 142 may connect a first electrode formed on the front surface of the solar cell 150 to a second electrode formed on the rear surface of another adjacent solar cell 150. That is, the two solar cells 150 can be connected through the ribbon 142 by placing the ribbon 142 extending from the front surface of the solar cell 150 to the rear surface of the other solar cell 150 and then thermally pressing the same.

The ribbon 142 may be made of a variety of materials exhibiting superior electrical properties and physical properties. For example, the ribbon 142 includes a soldering material, for example, Sn/Ag/Cu, Sn/Ag/Pb, Sn/Ag, Sn/Pb or the like. Alternatively, the ribbon 142 may be made of a highly conductive metal material (for example, aluminum). Alternatively, the ribbon 142 may be formed by laminating an anti-oxidation film on a soldering material. However, the embodiments of the invention are not limited to the ribbon material.

The term "ribbon 142" is used herein, but the embodiments of the invention are not limited thereto. That is, the ribbon 142 may include a structure connecting the solar cells 150 through a variety of structures as well as the soldering material.

In addition, the bus ribbon 145 alternately connects both ends of a row connected through the ribbon 142. The bus ribbon 145 may be disposed in a direction crossing the ribbon 142 at the end of solar cells 150 constituting the row. The bus ribbon 145 is connected to a junction box which collects electricity generated by the solar cell 150 and prevents reverse flow of electricity.

The first sealing material 131 may be disposed on the front surface of the solar cell 150, while the second sealing material 132 may be disposed on the rear surface of the solar cell 150. The first sealing material 131 is bonded to the second sealing material 132 by lamination, thereby blocking moisture or oxygen which may have a negative or deleterious effect on the solar cell 150, and enabling chemical bonding between the respective elements of the solar cell.

The first sealing material 131 and the second sealing material 132 may comprise an ethylene vinyl acetate (EVA) copolymer resin, a polyvinyl butyral resin, a silicone resin, an ester resin, an olefin resin or the like, but the embodiments of the invention are not limited thereto. Accordingly, the first and second sealing materials 131 and 132 may be formed using various other materials by a method other than the lamination.

Preferably, the front substrate 210 is disposed on the first sealing material 131 so that it transmits sunlight and is reinforced glass in order to protect the solar cell 150 from exterior shock. In addition, the front substrate 210 is more preferably formed of low-iron reinforced glass containing a small amount of iron so as to prevent reflection of sunlight and improve transmission of sunlight.

The rear sheet 220 is a layer which protects the solar cell 150 at the rear surface of the solar cell 150 and has waterproofing, insulation and UV blocking functions. The rear sheet 220 may be of a Tedlar/PET/Tedlar (TPT) type, but the embodiments of the invention are not limited thereto. In addition, the rear sheet 220 may be made of a material having high reflectivity so as to reflect sunlight emitted from the front substrate 210 and reuse the same, but the embodiments of the invention are not limited thereto. The rear sheet 220 may be made of a transparent material which admits incident sunlight so as to implement a bi-facial solar cell module 100.

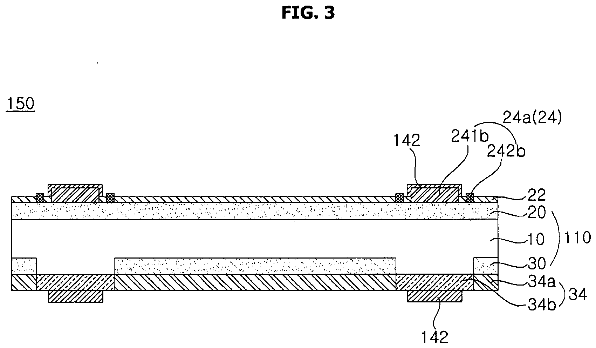

An example of a structure of one of the solar cells 150 will be described with reference to FIGS. 3 to 5 in detail.

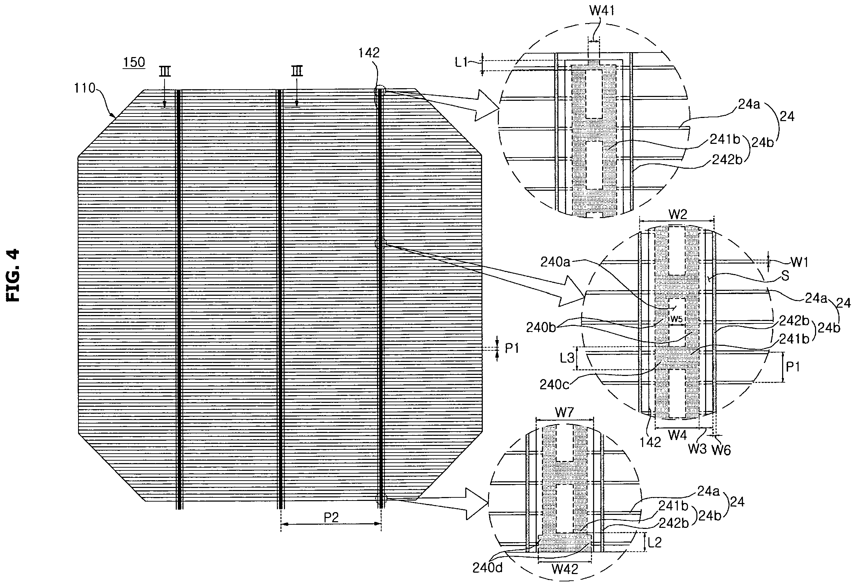

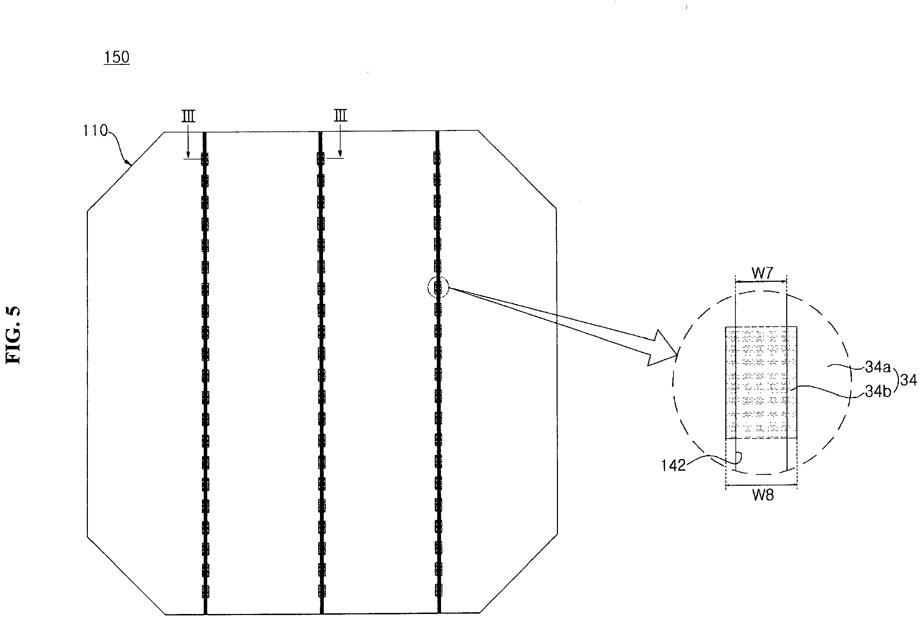

FIG. 3 is a partial sectional view illustrating the solar cell according to the embodiment. FIG. 4 is a front plan view illustrating the solar cell according to the embodiment, and FIG. 5 is a rear plan view illustrating the solar cell according to the embodiment. FIG. 3 is a sectional view taken along line III-III of FIGS. 4 and 5.

Referring to FIG. 3, the solar cell 150 includes a semiconductor substrate 110, impurity regions 20 and 30 formed on the semiconductor substrate 110, and electrodes 24 and 34 electrically connected to the impurity regions 20 and 30 or the semiconductor substrate 110. In addition, the solar cell 150 may include a ribbon 142 electrically connected to the electrodes 24 and 34 for connection of adjacent solar cells 150. The semiconductor substrate 110 and the impurity regions 20 and 30 are regions contributing to photoelectric conversion and are thus defined as photoelectric conversion portions. The impurity regions 20 and 30 may include an emitter region 20 and a rear electric field region 30, and the electrodes 24 and 34 may include a first electrode 24 electrically connected to the emitter region 20 and a second electrode 34 electrically connected to the rear electric field region 30. The solar cell 150 may further include an anti-reflective film 22, a passivation film and the like on the front surface and/or the rear surface of the semiconductor substrate 110. This will be described in more detail.

The semiconductor substrate 110 includes a region where the impurity regions 20 and 30 are formed, and a base region 10 which is a region where the impurity regions 20 and 30 are not formed. The base region 10 may comprise, for example, silicon comprising a first conductivity type impurity. The silicon may be monocrystalline silicon or polycrystalline silicon, and the first conductivity type impurity may be an n- or a p-type impurity.

The solar cell is described based on an example in which the first conductive type impurity is a p-type. When the base region 10 is a p-type, the base region 10 may be formed of monocrystalline or polycrystalline silicon doped with a Group III element such as boron (B), aluminum (Al), gallium (Ga) or indium (In). When the base region 10 is a p-type, the rear electric field region 30 is also a p-type and a process of forming the rear electric field region 30 is thus simplified. This will be described again later.

The front and rear surfaces of the semiconductor substrate 110 may be subjected texturing so that they have irregularities having a pyramidal shape or the like. The irregularities formed on the front and rear surfaces of the semiconductor substrate 110 by texturing cause an increase in surface roughness and thereby reduce reflection of light incident through the front and rear surfaces of the semiconductor substrate 110. Accordingly, an amount of light which reaches the p-n junction formed at the boundary between the semiconductor substrate 110 and the emitter region 20 is increased and light loss is thus minimized, but the embodiments of the invention are not limited thereto and irregularities may be not formed on the front and rear surfaces of the semiconductor substrate 110 by texturing.

The emitter region 20 having a second conductivity type opposite to the conductivity type of the base region 10 may be formed on the front surface of the semiconductor substrate 110. That is, the emitter region 20 may be formed of monocrystalline or polycrystalline silicon doped with the second conductivity type impurity, as a Group V element such as phosphorus (P), arsenic (As), bismuth (Bi) or antimony (Sb).

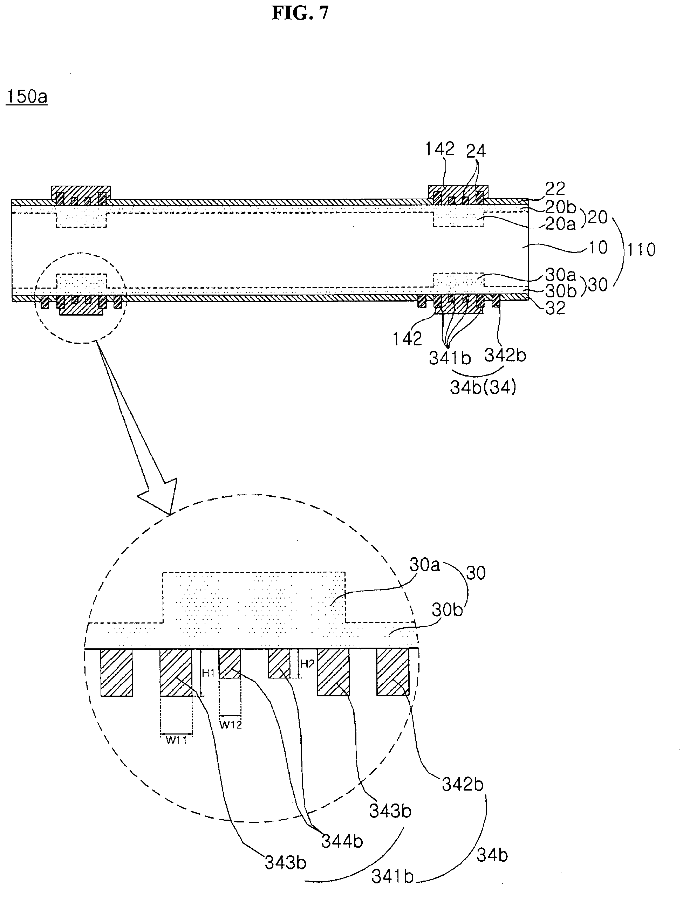

The drawing illustrates that the emitter region 20 has a homogeneous structure in which a doping concentration is entirely homogeneous, but the embodiments of the invention are not limited to this structure. In another embodiment, the emitter region 20 may have a selective structure. This structure will be described in more detail with reference to FIG. 7 later.

A doping region formed by doping a second conductivity type impurity on the front surface of the semiconductor substrate 110 constitutes the emitter region 20, but the embodiments of the invention are not limited thereto. The emitter region 20 may have a variety of forms, for example, a separate layer formed on the front surface of the semiconductor substrate 110.

The anti-reflection film 22 and the first electrode 24 are disposed on the semiconductor substrate 110, more specifically, on the emitter region 20 disposed on the semiconductor substrate 110.

The anti-reflection film 22 may be substantially formed over the entire surface of the semiconductor substrate 110, excluding a part corresponding to the first electrode 24. The anti-reflection film 22 reduces reflection of light incident upon the front surface of the semiconductor substrate 110 and passivates defects present on the surface or in the bulk of the emitter region 20.

By reducing reflection of light incident upon the front surface of the semiconductor substrate 110, an amount of light which reaches the p-n junction formed at the boundary between the semiconductor substrate 110 and the emitter region 20 is increased. Accordingly, short-circuit current (Isc) of the solar cell 150 is increased. In addition, defects present in the emitter region 20 are passivated, recombination sites of minority carriers are removed and open-circuit voltage (Voc) of the solar cell 150 is thus increased. As such, open-circuit voltage and short-circuit current of the solar cell 150 are increased by the anti-reflective film 22 and efficiency of the solar cell 150 is thus increased.

The anti-reflective film 22 may be formed of various materials. For example, the anti-reflective film 22 may have a single film structure including one selected from the group consisting of a silicon nitride film, a silicon nitride film containing hydrogen, a silicon oxide film, a silicon oxide nitride film, an aluminum oxide film, MgF₂, ZnS, TiO₂ and CeO₂, or a multi-film structure including two or more thereof. However, the embodiments of the invention are not limited to the structure of the anti-reflective film 22 and the anti-reflective film 22 may comprise various materials. A separate front passivation film may be further provided for passivation between the semiconductor substrate 110 and the anti-reflective film 22. This also falls within the scope of the embodiments of the invention.

The first electrode 24 is electrically connected to the emitter region 20 through an opening formed on the anti-reflective film 22 (that is, while passing through the anti-reflective film 22). The first electrode 24 may be formed in various shapes using various materials. The shape of the first electrode 24 will be described later with reference to FIG. 4.

A rear electric field region 30 having the same first conductivity type as the base region 10 and comprising a first conductivity type impurity in a higher doping concentration than the semiconductor substrate 110 is formed on the rear surface of the semiconductor substrate 110. In the embodiment of the invention, the rear electric field region 30 may be formed using, as a p-type impurity, a Group III element such as boron (B), aluminum (Al), gallium (Ga) or indium (In).

The rear electric field region 30 having a local structure may be formed by diffusing an element contained in the second electrode 34 into the semiconductor substrate 110 by thermal treatment. For example, when the second electrode 34 comprises aluminum (Al), the second electrode 34 is formed by applying a paste comprising aluminum (Al) to the rear surface of the semiconductor substrate 110, followed by baking. At the same time, the rear electric field region 30 may also be formed by diffusing aluminum into the semiconductor substrate 110. Accordingly, the rear electric field region 30 may be formed by a simple process, but the embodiments of the invention are not limited thereto. For formation of the rear electric field region 30, a separate doping process (such as thermal diffusion, laser doping or ion implantation) may be performed.

The second electrode 34 includes an electrode portion 34a and a pad portion 34b, the electrode portion 34a includes a first conductivity type impurity, and the rear electric field region 30 has a local structure in which the rear electric field region 30 is locally formed in a region in which the electrode portion 34a is formed, but the embodiments of the invention are not limited thereto. That is, when the second electrode 34 does not include a separate pad portion 34b and includes a first conductivity type impurity such as aluminum, a front electric field region may have a homogeneous structure in which a doping concentration is entirely homogeneous. In another embodiment, as shown in FIG. 7, the rear electric field region 30 may have a selective structure. This will be described in more detail with reference to FIG. 7 later.

In addition, a doping region formed by doping a first conductivity type impurity on the rear surface of the semiconductor substrate 110 constitutes the rear electric field region 30, but the embodiments of the invention are not limited thereto. The rear electric field region 30 may have a variety of forms, for example, a separate layer formed on the rear surface of the semiconductor substrate 110.

The second electrode 34 is electrically connected to the rear electric field region 30. Such a second electrode 34 may be formed as various shapes using various materials. The shape of the second electrode 34 will be described later with reference to FIG. 5.

Referring to FIG. 4, the first electrode 24 includes a plurality of finger electrodes 24a and at least one bus bar electrode 24b disposed in a direction crossing the finger electrodes 24a. In this instance, the finger electrodes 24a may have a first pitch P1 and be disposed in parallel to each other. In addition, the bus bar electrode 24b may be formed in a direction crossing the finger electrodes 24a and connect the finger electrodes 24a. The bus bar electrode 24b may be only one in number, or a plurality of bus bar electrodes 24b including the bus bar electrode 24b having a second pitch P2 larger than the first pitch P1 may be provided, as shown in FIG. 4.

The finger electrodes 24a have a width W1 smaller than a width W2 of the bus bar electrode 24b, thereby minimizing shading loss that may be generated by the area of the first electrode 24. In this instance, the width W1 of the finger electrode 24a and the width W2 of the bus bar electrode 24b refer to a width between the outermost edges of the finger electrodes 24a or the bus bar electrode 24b. That is, the width W2 of the bus bar electrode 24b refers to a distance between peripheral edges of two auxiliary bus bars 242b disposed at the periphery.

In this instance, the bus bar electrode 24b includes a main bus bar 241b and an auxiliary bus bar 242b adjacent to the main bus bar 241b such that the auxiliary bus bar 242b is spaced from the main bus bar 241b by a spacing area S having a predetermined width W3.

Here, the main bus bar 241b is a portion of the bus bar electrode 24b, to which the ribbon 142 is adhered. The first electrode 24 is disposed on the front surface of the solar cell 150. The main bus bar 241b includes an opening 240a so as to maintain a width W4 of the main bus bar 241b (more specifically, a width between peripheral edges of the main bus bar 241b in the middle of the main bus bar 241b), to reduce a material for forming the main bus bar 241b and to decrease shading loss. That is, the opening 240a, an empty region where an electrode is not formed, is disposed between peripheral edges of the main bus bar 241b.

For example, a plurality of openings 240a having a predetermined width W5 may be disposed such that the openings 240a are arranged in a row in a longitudinal direction of the main bus bar 241b. Only one opening 240a is disposed in the width W4 direction of the main bus bar 241b so that the width W5 of the opening 240a is maximized and an amount of the material and a shading loss are thus minimized. For example, a ratio of the width W4 of the main bus bar 241b to the width W5 of the opening 240a (W4:W5) may be 1:0.2 to 1:0.8. When the ratio (W4:W5) exceeds 1:0.2, it is difficult to minimize the amount of the material and shading loss, and when the ratio (W4:W5) is less than 1:0.8, an area where the ribbon 142 contacts the main bus bar 241b may be insufficient, but the embodiments of the invention are not limited thereto and the ratio (W4:W5) or the like may be changed.

In addition, the openings 240a are spaced from one another in a longitudinal direction of the main bus bar 241b. As a result, a bridge electrode portion 240c for connecting the openings 240a is provided in the longitudinal direction of the main bus bar 241b. That is, the main bus bar 241b includes two main electrode portions 240b disposed at both sides of the opening 240a in a width direction and a plurality of bridge electrode portions 240c for connecting the two main electrode portions 240b. The area in which the main bus bar 241b contacts the ribbon 142 can be maximized although the openings 240a are provided through the main electrode portions 240b and the bridge electrode portions 240c. In addition, carriers may be moved via other routes although some of the main electrode portions 240b and the bridge electrode portions 240c are damaged.

A distance L3 between two adjacent openings 240a (that is, a thickness of the bridge electrode portion 240c) may be constant in the middle of the main bus bar 241b. In addition, a distance L1 between one of the openings 240a, adjacent to a side of the main bus bar 241b (upper side of the drawing, hereinafter, referred to as "upper side"), and an upper side of the main bus bar 241b is different from a distance L2 between another of the openings 240a, adjacent to another side of the main bus bar 241b (lower side of the drawing, referred to as a "lower side"), and another side of the main bus bar 241b. More specifically, the first distance L1 is less than the third distance L3 and the third distance L3 is less than the second distance L2. This is determined in consideration of the connection structure of the ribbon 142.

More specifically, the upper side of the main bus bar 241b is a region where an end of the ribbon 142 is disposed and the lower side of the main bus bar 241b is a region where the ribbon 142 extends and is connected to adjacent another solar cell.

In consideration of alignment errors, defects and the like, the ribbon 142 is adhered at a position spaced by a predetermined distance from an edge of the main bus bar 241b at the upper side of the main bus bar 241b where an end of the ribbon 142 is disposed. That is, the end of the ribbon 142 is spaced from the edge of the upper side of the solar cell 150. As a result, a region where the main bus bar 241b does not directly contact the ribbon 142 may be disposed at the edge of the upper side of the main bus bar 241b. Accordingly, a formation area of the main bus bar 241b is reduced at the edge of the upper side of the main bus bar 241b which does not directly contact the ribbon 142, and the amount of material for forming the bus bar electrode 24b and a shading loss are thus minimized. Further, a width W41 of the main bus bar 241b at the edge of the upper side of the main bus bar 241b is less than the width W4 of the main bus bar 241b in the middle of the main bus bar 241b so that an area of the edge of the upper side of the main bus bar 241b can be further decreased.

In addition, force applied from the ribbon 142 to the lower side of the main bus bar 241b is great, as compared to the upper side of the main bus bar 241b, and defects such as cracks are thus more readily generated at the lower side of the main bus bar 241b. In consideration of this feature, the second distance L2 of the other side of the main bus bar 241b at which the ribbon 142 extends is controlled to a relatively great level so that the main bus bar 241b has a sufficient area at the other side thereof. Protrusions 240d protruding from both sides of the main bus bar 241b are disposed at the other side thereof so that the main bus bar 241b has a width W42 greater than the width W4 of the middle region of the main bus bar 241b. As a result, a sufficient contact area is provided at the other side of the main bus bar 241b.

However, the configuration of the main bus bar 241b and the configuration, disposition or the like of the opening 240a are not limited to those described above. That is, the plurality of openings 240a may be disposed in a width direction of the main bus bar 241b, one opening 240a may be provided, or the bridge electrode portion 240c may be omitted. Various other modifications are possible.

The auxiliary bus bar 242b is a region where the ribbon 142 may be adhered upon generation of process errors, although the ribbon 142 is not adhered according to design. In addition, the auxiliary bus bar 242b provides a bypass route, inducing carriers to move to the main bus bar 241b. This will be described in more detail.

During a process for connecting the ribbon 142 onto the main bus bar 241b (for example, a tabbing process), a soldering portion of the ribbon 142 may flow onto the finger electrodes 24a adjacent to the main bus bar 241b. The finger electrodes 24a may be cracked due to the flowing soldering portion because the finger electrodes 24a have a small width W1. When thermal shock is applied by the cracks, a portion of the finger electrodes 24a adjacent to the main bus bar 241b may be readily disconnected. This phenomenon is called grid interruption caused by soldering (GICS). When the portion of the finger electrodes 24a adjacent to the main bus bar 241b is disconnected by the GICS, the carriers are moved to another main bus bar 241b or do not reach the main bus bar 241b, instead of moving to the corresponding main bus bar 241b. As a result, power of the solar cell 150 is decreased.

When the main bus bar 241b and the auxiliary bus bar 242b are simultaneously formed, carriers reach the main bus bar 241b through the auxiliary bus bar 242b, although the finger electrodes 24a adjacent to the main bus bar 241b are disconnected due to GICS. That is, the auxiliary bus bar 242b functions to transfer carriers to the main bus bar 241b by a bypass route.

The auxiliary bus bar 242b is formed adjacent to the main bus bar 241b such that the auxiliary bus bar 242b is spaced from the main bus bar 241b by a spacing area S. As such, the width W2 of the bus bar electrode 24b can be increased, as compared to a conventional case, by forming the auxiliary bus bar 242b while securing the spacing area S outside of the main bus bar 241b. As a result, although an alignment error or the like is generated upon adhesion of the ribbon 142, the ribbon 142 can be stably connected to the bus bar electrode 24b. In this instance, the bus bar electrode 24b having a large width W2 is not formed over the entire region and the main bus bar 241b and the auxiliary bus bar 242b are formed to be spaced from each other by the spacing area S, thereby reducing the amount of the material for forming the bus bar electrode 24b and minimizing shading loss. In addition, as described above, the auxiliary bus bar 242b provides a bypass route and thereby improves carrier collection efficiency.

Here, the width W3 of the spacing area S is equal to or less than the first pitch P1 of the finger electrode 24a. In this instance, the width W3 of the spacing area S refers to a distance between an outer edge of the main bus bar 241b (that is, an edge adjacent to the auxiliary bus bar 242b) and an inner edge of the auxiliary bus bar 242b (that is, an edge adjacent to the main bus bar 241b). When the width W3 of the spacing area S is greater than the first pitch P1 of the finger electrode 24a, the auxiliary bus bar 242b may substantially not contribute to a stable connection with the ribbon 142 due to the spacing area S being greater than the alignment error, and the auxiliary bus bar 242b may not sufficiently perform the function of providing a bypass route.

For example, a ratio of the first pitch P1 of the finger electrode 24a to the width W3 of the spacing area S (P1:W3) may be 1:0.0025 to 1:1. When the ratio (P1:W3) exceeds 1:0.0025, the bus bar electrode 24b may not have a sufficient width W2 in consideration of an alignment error or the like due to a small width W3 of the spacing area S. When the ratio (P1:W3) is less than 1:1, the auxiliary bus bar 242b may not sufficiently perform its function, as described above. In this instance, the ratio (P1:W3) may be 1:0.25 to 1:0.75 (more specifically, 1:0.25 to 1:0.5) so that the bus bar electrode 24b has a sufficient width W2 and the spacing area S has an appropriate width W3.

A ratio of the width W2 of the bus bar electrode 24b to the width W3 of the spacing area S (W2:W3) may be 1:0.2 to 1:0.4. When the ratio (W2:W3) exceeds 1:0.2, it may be difficult to sufficiently secure the width W2 of the bus bar electrode 24b due to a small width W3 of the spacing area S and it may be difficult to minimize the amount of material and shading loss of the bus bar electrode 24b. When the ratio (W2:W3) is less than 1:0.4, it may be difficult to sufficiently secure the width W4 of the main bus bar 241b due to a great width W3 of the spacing area S and connection with the ribbon 142 may thus be deteriorated.

The width W6 of the auxiliary bus bar 242b may be a level or an amount enough or sufficient so that the auxiliary bus bar 242b functions as the bus bar electrode 24b upon adhesion of the ribbon 142 and provides the bypass route of carriers. For example, a ratio of the width W1 of the finger electrodes 24a to the width W6 of the auxiliary bus bar 242b is 1:0.6 to 1:1.5. When the ratio (W1:W6) exceeds 1:0.6, the auxiliary bus bar 242b may not sufficiently perform its function and when the ratio (W1:W6) is less than 1:1.5, the amount of material and shading loss may be increased due to the auxiliary bus bar 242b. In this instance, the auxiliary bus bar 242b is formed to have a width greater than the width of the finger electrode 24a (that is, the ratio (W1:W6) is adjusted to 1:1 to 1:1.5), thereby reducing damage to the auxiliary bus bar 242b upon generation of GICS or the like.

The ribbon 142 is disposed on the bus bar electrode 24b. As described above, the ribbon 142 functions to connect adjacent solar cells 150 and has a variety of structures including various materials. Although the ribbon contacts the bus bar electrode 24b as described with reference to the drawing, the embodiments of the invention are not limited thereto. That is, an adhesion layer, an adhesion film or the like may be further provided between the bus bar electrode 24b and the ribbon 142.

A width W7 of the ribbon 142 may be equal to or less than the width W2 of the bus bar electrode 24b and may be equal to or less than the width W4 of the main bus bar 241b. As a result, the ribbon 142 is connected to the main bus bar 241b in a sufficiently large area and a difference in area between the ribbon 142 and the main bus bar 241b is thus minimized. In addition, although GICS is generated, a bypass route can be formed by the auxiliary bus bar 242b disposed at the periphery of the bus bar electrode 24b.

For example, a ratio of the width w7 of the ribbon 142 to the width W2 of the bus bar electrode 24b (W7:W2) may be 1:1 to 1:3. When the ratio (W7:W2) is less than 1:1, GICS may be generated due to a great width W7 of the ribbon 142. When the ratio (W7:W2) exceeds 1:3, an area where the ribbon 142 is connected to the bus bar electrode 24b may be decreased due to a small width W7 of the ribbon 142. To secure a sufficient connection area, the ratio (W7:W2) is 1:1 to 1:2.2.

Referring to FIG. 5, the second electrode 34 which is a rear electrode formed on the rear surface of the semiconductor substrate 110 is formed over the entire rear surface of the semiconductor substrate 110. As a result, an area of the rear electric field region 30 formed using the second electrode 34 can be maximized because the semiconductor substrate 110 is a p-type. Accordingly, recombination on the rear surface of the semiconductor substrate 110 can be prevented or reduced. In addition, the second electrode 34 formed over the entire rear surface of the semiconductor substrate 110 reflects light on the rear surface of the semiconductor substrate 110 and guides the light into the semiconductor substrate 110, thereby enabling reuse of light. As a result, efficiency of the solar cell 150 can be improved.

In this instance, the second electrode 34 includes a pad portion 34b formed in a region where the ribbon 142 is disposed and an electrode portion 34a formed in a region excluding the pad portion 34b. The pad portion 34b may include a plurality of parts spaced from one another in the longitudinal direction of the ribbon 142. As a result, a formation area of the electrode portion 34a is maximized and a formation area of the rear electric field region 30 is maximized, thus reducing the amount of the material required for formation of the pad portion 34b. In this instance, the width W8 of the pad portion 34b may be greater than the width W7 of the ribbon 142. For this reason, although an alignment error or the like is generated, the pad portion 34b can be stably connected to the ribbon 142, but the embodiments of the invention are not limited thereto and the width W8 of the pad portion 34b may be varied.

The pad portion 34b and the electrode portion 34a having different materials enable improvement of various properties. That is, the pad portion 34b improves connection with the ribbon 142 and the electrode portion 34a enables easy formation of the rear electric field region 30. The pad portion 34b may be made of a material (for example, silver (Ag)) having a superior connection property to the ribbon 142. The electrode portion 34a may be made of a material (for example, aluminum (Al)) having a superior electrical conductivity and reflectivity and being suitable for formation of the rear electric field region 30, but the embodiments of the invention are not limited thereto and configuration, structure, material and the like of the second electrode 34 may be varied. That is, the second electrode 34 may be formed in a predetermined pattern (for example, pattern that is the same as or similar to the first electrode 24), and the second electrode 34 may exclusively include the electrode portion 34a, without the pad portion 34b. In addition, materials for the pad portion 34b and the electrode portion 34a may be varied. In addition, the rear electric field region 30 may be formed by various methods, for example, by a separate doping, instead of being formed using the second electrode 34.

As described above, the auxiliary bus bar 242b is formed adjacent to the main bus bar 241b such that the auxiliary bus bar 242b has a width W3 smaller than the first pitch P1 of the finger electrodes 24a. As a result, the bus bar electrode 24b is formed to have a large width W2, so that the bus bar electrode 24b can be stably connected to the ribbon 142, the amount of the material for forming the bus bar electrode 24b can be reduced, and a shading loss can be minimized. In addition, as described above, the auxiliary bus bar 242b provides a bypass route and thereby improves carrier collection efficiency.

When the base region 10 is a p-type, the first electrode 24 which is the front electrode includes the auxiliary bus bar 242b, and the second electrode 34 is entirely formed, but the embodiments of the invention are not limited thereto. Accordingly, the second electrode 34 may include the auxiliary bus bar and the first electrode 24 may not include the auxiliary bus bar 242b, or both the first and second electrodes 24 and 34 may include the auxiliary bus bar 242b. That is, one of the first and second electrodes 24 and 34 may include the auxiliary bus bar 242b. In addition, modifications are possible, for example, the base region 10 and the rear electric field region 30 may be an n-type and the emitter region 20 may be a p-type.

In addition, an example in which an auxiliary bus bar 242b is disposed at both sides of the main bus bar 241b has been described, but the embodiments of the invention are not limited thereto. That is, the auxiliary bus bar 242b may be disposed at only a side of the main bus bar 241b. In addition, the auxiliary bus bar 242b may extend lengthwise like the main bus bar 241b so as to be continuous and/or may be partially formed only in a predetermined region so as to be discontinuous. Various other modifications are possible. For example, the auxiliary bus bar 242b need not extend parallel to the main bus bars 241b. The auxiliary bus bar 242b may extend perpendicularly, or at an angle to the main bus bar 241b, in embodiments of the invention, such as when the auxiliary bus bar 242b are discontinuous.

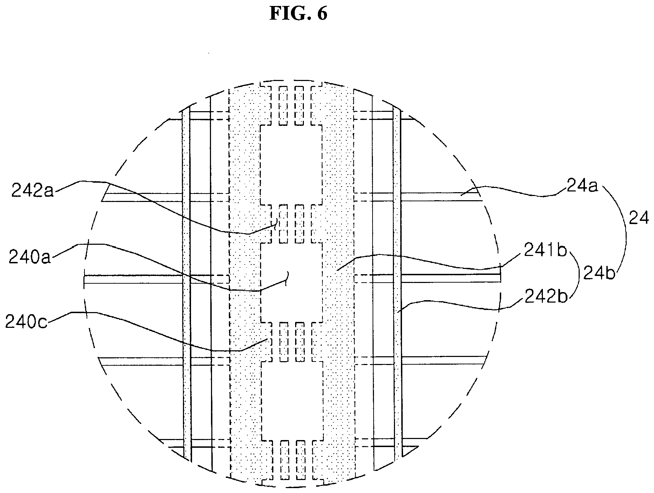

Hereinafter, a solar cell will be described in detail with reference to FIGS. 6 to 8. A detailed description of elements the same as or similar to those already described above in the following description is omitted and only different or additional elements are described in detail.

FIG. 6 is a partial front plan view illustrating a solar cell.

Referring to FIG. 6, a second opening 242a is formed in the bridge electrode portion 240c of the first electrode 24 according to the embodiment of the invention. For example, a plurality of second openings 242a are formed in one bridge electrode portion 240c disposed between the two first openings 240a, thereby minimizing an area of the first electrode 24. For this reason, an amount of the material for forming the first electrode 24 can be minimized.

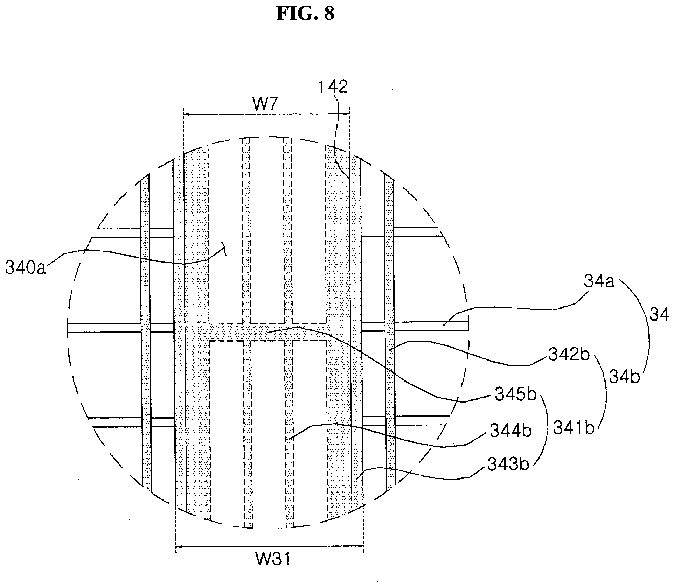

FIG. 7 is a partial sectional view illustrating a solar cell according to an embodiment of the invention and FIG. 8 is a partial rear plan view illustrating the solar cell shown in FIG. 7. FIG. 8 shows a part corresponding to an enlarged circle shown in FIG. 7.

Referring to FIGS. 7 and 8, in the solar cell 150a according to the embodiment of the invention, first and second electrodes 24 and 34 are formed in different patterns. That is, the first and second electrodes 24 and 34 having a predetermined pattern are formed so that light can be incident upon the front and rear surfaces of the solar cell 150a. That is, the solar cell 150a may have a bi-facial structure.

In the embodiment of the invention, the base region 10 and the rear electric field region 30 may be an n-type and the emitter region 20 may be a p-type. When the base region 10 having n-type impurities is used, the emitter region 20 having p-type impurities is formed on the first surface of the semiconductor substrate 110, thus providing pn junction. Upon emission of light to the pn junction, electrons produced by photoelectric conversion effect move to the rear surface of the semiconductor substrate 110 and are collected by the second electrode 34, and holes move to the first surface of the semiconductor substrate 110 and are collected by the first electrode 24. As a result, electrical energy is generated. Accordingly, holes having a lower movement rate than electrons are moved to the front surface of the semiconductor substrate 110, rather than the rear surface of the semiconductor substrate 110, thereby improving a conversion efficiency.

The emitter region 20 has a selective structure, as illustrated. That is, the emitter region 20 includes a first portion 20a which has a high doping concentration and thus a relatively low resistance and a second portion 20b which has a low doping concentration and thus a relatively high resistance. As a result, the second portion 20b having a relatively high resistance is formed between the first electrodes 24 upon which light is incident, thereby implementing a shallow emitter. As a result, a current density of the solar cell 150a can be improved. Furthermore, the first portion 20a having a relatively low resistance is formed in a region adjacent to the first electrode 24, thereby reducing a contact resistance with the first electrode 24. When the emitter region 20 has a selective structure, efficiency of the solar cell 150a can be maximized. However, the emitter region 20 may have various structures, as described above.

In addition, the rear electric field region 30 has a selective structure, as described above. That is, the rear electric field region 30 includes a first portion 30a which has a high doping concentration and thus a relatively low resistance and a second portion 30b which has a low doping concentration and thus a relatively high resistance. As a result, the second portion 30b having a relatively high resistance is formed between the second electrodes 34, thereby minimizing surface recombination. As a result, a current density of the solar cell 150a can be improved. Furthermore, the first portion 30a having a relatively low resistance is formed in a region adjacent to the second electrode 34, thereby reducing a contact resistance with the second electrode 34. When the rear electric field region 30 has a selective structure, efficiency of the solar cell 150a can be maximized. However, the rear electric field region 30 may have various structures, as described above.

In the embodiment of the invention, the second electrode 34 may include a finger electrode 34a and a bus bar electrode 34b, and the bus bar electrode 34b may include a main bus bar 341b and an auxiliary bus bar 342b.

In this instance, a plurality of openings 340a are disposed in a width direction of the main bus bar 341b and the main bus bar 341b includes a plurality of main electrode portions 343b and 344b such that the openings 340a are interposed therebetween. The width of the openings 340a, the width of the main electrode portions 343b and 344b and the like may be varied according to the number of the openings 340a and the main electrode portions 343b and 344b.

The main electrode portions 343b and 344b may extend lengthwise in a longitudinal direction of the main bus bar 341b. In addition, the main electrode portions 343b and 344b include two first main electrode portions 343b at both sides and a second main electrode portion 344b disposed between the first main electrode portions 343b. The first main electrode portion 343b has a width and thickness different from those of the second main electrode portion 344b.

For example, the width W11 of the first main electrode portion 343b is greater than a width W12 of the second main electrode portion 344b and a thickness (or height H1) of the first main electrode portion 343b is greater than a thickness (or height H2) of the second main electrode portion 344b. The first and second main electrode portions 343b and 344b having such a configuration can be easily formed, upon formation of electrodes by printing or the like, using the fact that the thickness increases with an increase in a width of a paste for electrodes and the thickness decreases with a decrease in the width based on the aspect ratio.

By forming the first and second main electrode portions 343b and 344b to have different widths and thicknesses, accuracy is improved upon testing for evaluating properties or the like of the solar cell 150a and the amount of material required for formation of the second electrode 34 is reduced. That is, the width of the opening 340a is decreased and the main electrode portions 343b and 344b are densely disposed, thereby stably mounting a probe on the second electrode 34 upon testing properties of the solar cell 150a. Further, the amount of the material required for formation of the second electrode 34 can be reduced by reducing the width W12 and the thickness H2 of the second main electrode portions 344b disposed in an inner part.

In addition, the main bus bar 341b may further include a bridge electrode portion 345b which is disposed in a direction crossing the first and second main electrode portions 343b and 344b and connects the first and second main electrode portions 343b and 344b. As a result, although parts of the first and second main electrode portions 343b and 344b are disconnected, carriers are moved via other first and second main electrode portions 343b and 344b. In addition, a connection area (or a contact area) between the main bus bars 341b and the ribbon 142 can be maximized.

In the embodiment of the invention, the second electrode 34 including the auxiliary bus bar 342b is a rear electrode disposed on the rear surface of the solar cell 150a. That is, the second electrode 34 upon which a relatively low amount of light is incident includes the main bus bar 341b and the auxiliary bus bar 342b, thus enabling the formation of the main bus bars 341b with a sufficient width W31 or the like. For example, in the embodiment of the invention, unlike the embodiments shown in FIGS. 1 to 5, the width W31 of the main bus bar 341b may be greater than the width W7 of the ribbon 142, but the embodiments of the invention are not limited thereto and various modifications are possible.

In the embodiment of the invention, the first electrode 24 may include a finger electrode and a bus bar electrode similar to the finger electrode 34a of the second electrode 34 and the bus bar electrode 34b of the second electrode 34 including the main bus bar 341b. The first electrode 24 may not include an element corresponding to the auxiliary bus bar 342b of the second electrode 34, because the first electrode 24 is disposed on the first surface of the semiconductor substrate 110, upon which a great amount of light is incident. As a result, shading loss can be minimized.

As described in the afore-mentioned embodiment, when the base region 10 is an n-type, the first electrode 24 as the front electrode does not include an auxiliary bus bar and the second electrode 34 includes an auxiliary bus bar 342b, but the embodiments of the invention are not limited thereto.

That is, the first electrode 24 may include a finger electrode and a bus bar electrode similar to the finger electrode 34a of the second electrode 34 and the bus bar electrode 34b including the main bus bar 341b and the auxiliary bus bar 342b. Alternatively, the first electrode 24 may have a shape as shown in FIG. 4. The first electrode 24 may have various other shapes. In addition, when the first electrode 24 includes an auxiliary bus bar, the second electrode 34 may not include an auxiliary bus bar 342b. Alternatively, shapes of the main bus bars 341b of the first electrode 24 and the second electrode 34 may be varied. In addition, the base region 10 and the rear electric field region 30 may be a p-type and the emitter region 20 may be an n-type.

In addition, an example in which the auxiliary bus bar 342b of the second electrode 34 is disposed at both sides of the main bus bar 341b has been described, but the embodiments of the invention are not limited thereto. That is, the auxiliary bus bar 342b may be disposed at only one side of the main bus bar 341b. In addition, the auxiliary bus bar 342b may extend lengthwise so as to be continuous, like the main bus bars 341b, and/or may be partially formed only in a predetermined region so as to be discontinuous. Various other modifications are possible. For example, the auxiliary bus bar 342b need not extend parallel to the main bus bars 341b. The auxiliary bus bar 342b may extend perpendicularly, or at an angle to the main bus bar 341b, in embodiments of the invention, such as when the auxiliary bus bar 342b are discontinuous.

The features, structures and effects illustrated in the above embodiments may be included in at least one embodiment of the invention but are not limited to one embodiment. Further, those skilled in the art will appreciate that various combinations and modifications of the features, structures and effects illustrated in the respective embodiments are possible. Therefore, it will be understood that these combinations and modifications are covered by the scope of the invention.

## Claims

1. A solar cell (150) comprising:
a photoelectric conversion portion (110, 20, 30); and
first and second electrodes (24, 34) connected to the photoelectric conversion portion (110, 20, 30),
wherein at least one of the first and second electrodes (24, 34) comprises:
a plurality of finger electrodes (24a); and
at least one bus bar electrode (24b) formed in a direction crossing the finger electrodes (24a),
wherein the bus bar electrode (24b) comprises:
a main bus bar (341b); and
an auxiliary bus bar (342b) formed adjacent to the main bus bar (341b) such that the auxiliary bus bar (342b) is spaced from the main bus bar (341b) by a spacing area (S),
wherein the spacing area (S) has a width (W3) less than a pitch (P1) of the plurality of finger electrodes (24a), **characterised in that** a ratio of a width (W1) of the plurality of finger electrodes (24a) to a width (W6) of the auxiliary bus bar (342b) is 1:1 to 1:1.5, and **in that** the main bus bar (341b) comprises a plurality of main electrode portions (343b, 344b) and a plurality of openings (340a) disposed in a width direction of the main bus bar (341b) and the plurality of main electrode portions (343b, 344b) is disposed such that the plurality of openings (340a) are interposed therebetween,
wherein the plurality of main electrode portions (343b, 344b) comprises:
first main electrode portions (343b) disposed at both sides of the main bus bar (341b); and
a second main electrode portion (344b) disposed between the first main electrode portions (343b), and
wherein at least one of a width (W11) and a thickness (H1) of the first main electrode portion (343b) is different from that (W12, H2) of the second main electrode portion (344b).

2. The solar cell (150) according to claim 1, wherein at least one of the following is fulfilled:
wherein a ratio of the pitch (P1) of the plurality of finger electrodes (24a) to the width (W3) of the spacing area (S) is 1:0.0025 to 1:1; and
wherein a ratio of a width (W2) of the bus bar electrode (24b) to the width (W3) of the spacing area (S) is 1:0.2 to 1:0.4.

3. The solar cell (150) according to claim 1, further comprising a ribbon (142) connected to the bus bar electrode (24b),
wherein a width (W7) of the ribbon (142) is equal to or less than a width of the bus bar electrode (24b), and
the width (W7) of the ribbon (142) is equal to or greater than a width (W4) of the main bus bar (241b).

4. The solar cell (150) according to claim 3, wherein a ratio of the width (W7) of the ribbon (142) to the width (W2) of the bus bar electrode (24b) is 1:1 to 1:3.

5. The solar cell (150) according to claim 1, wherein at least one of the following is fulfilled:
wherein the first electrode (24) of the first and second electrodes (24, 34) comprises the plurality of finger electrodes (24a) and the bus bar electrode (24b) comprises the main bus bar (341b) and the auxiliary bus bar (342b), and the first electrode (24) is a front electrode disposed on a front surface of the solar cell (150); and
wherein the first electrode (24) of the first and second electrodes (24, 34) comprises the plurality of finger electrodes (24a) and the bus bar electrode (24b) comprises the main bus bar (341b) and the auxiliary bus bar (342b), the photoelectric conversion portion (110, 20, 30) comprises a semiconductor substrate (110) comprising a base region (10) and an emitter region (20) formed on the semiconductor substrate (110), the base region (10) is a p-type and the emitter region (20) is an n-type, and the first electrode (24) is connected to the emitter region (20).

6. The solar cell (150) according to claim 5, further comprising a ribbon (142) connected to the second electrode (34), wherein the second electrode (34) comprises:
a pad portion (34b) formed in a region in which the ribbon (142) is connected; and
an electrode portion (34a) entirely formed over a region excluding the pad portion (34b).

7. The solar cell (150) according to claim 1, wherein at least one of the following is fulfilled:
wherein bus bar electrode (24b) further comprises at least one bridge electrode portion (240c) for connecting the plurality of main electrode portions (240b) in a direction crossing a longitudinal direction of the plurality of main electrode portions (240b);
wherein the second electrode (34) of the first and second electrodes (24, 34) comprises the plurality of finger electrodes (34a) and the bus bar electrode (34b) comprising the main bus bar (341b) and the auxiliary bus bar (342b), and the second electrode (34) is a rear electrode disposed on a rear surface of the solar cell (150); and
wherein the second electrode (34) of the first and second electrodes (24, 34) comprises the plurality of finger electrodes (34a) and the bus bar electrode (34b) comprising the main bus bar (341b) and the auxiliary bus bar (342b), the photoelectric conversion portion (110, 20, 30) comprises a semiconductor substrate (110) and an emitter region (20) and a rear electric field region (30) formed on the semiconductor substrate (110), the rear electric field region (30) is an n-type and the emitter region (20) is a p-type, and the second electrode (34) is connected to the rear electric field region (30).

## Patentansprüche

1. Solarzelle (150) umfassend:
einen photoelektrischen Umwandlungsabschnitt (110, 20, 30); und
erste und zweite Elektroden (24, 34), die mit dem photoelektrischen Umwandlungsabschnitt (110, 20, 30) verbunden sind,
wobei mindestens eine der ersten und zweiten Elektroden (24, 34) umfasst:
eine Mehrzahl von Fingerelektroden (24a); und
zumindest eine in einer die Fingerelektroden (24a) kreuzenden Richtung ausgebildete Sammelschienenelektrode (24b),
wobei die Sammelschienenelektrode (24b) umfasst:
eine Hauptsammelschiene (341b); und
eine an die Hauptstromschiene (341b) angrenzend ausgebildete Hilfssammelschiene (342b), so dass die Hilfssammelschiene (342b) durch einen Abstandsbereich (S) von der Hauptsammelschiene (341b) beabstandet ist,
wobei der Abstandsbereich (S) eine Breite (W3) kleiner als ein Pitch (P1) der Mehrzahl von Fingerelektroden (24a) aufweist,
**dadurch gekennzeichnet, dass**
ein Verhältnis einer Breite (W1) der Mehrzahl von Fingerelektroden (24a) zu einer Breite (W6) der Hilfssammelschiene (342b) 1:1 bis 1:1,5 beträgt,
und dass die Hauptsammelschiene (341b) eine Mehrzahl von Hauptelektrodenabschnitten (343b, 344b) und eine Mehrzahl von Öffnungen (340a) umfasst, die in einer Breitenrichtung der Hauptsammelschiene (341b) angeordnet sind, und die Mehrzahl von Hauptelektrodenabschnitten (343b, 344b) so angeordnet ist, dass die mehreren Öffnungen (340a) dazwischen angeordnet sind,
wobei die Mehrzahl von Hauptelektrodenabschnitten (343b, 344b) umfasst:
erste Hauptelektrodenabschnitte (343b), die zu beiden Seiten der Hauptsammelschiene (341b) angeordnet sind; und
ein zwischen den ersten Hauptelektrodenabschnitten (343b) angeordneter zweiter Hauptelektrodenabschnitt (344b) und
wobei eine Breite (W11) und/oder eine Dicke (H1) des ersten Hauptelektrodenabschnitts (343b) verschieden ist von der (W12, H2) des zweiten Hauptelektrodenabschnitts (344b).

2. Solarzelle (150) nach Anspruch 1, wobei mindestens eines der folgenden Merkmale erfüllt ist:
wobei ein Verhältnis des Pitches (P1) der Mehrzahl von Fingerelektroden (24a) zur Breite (W3) des Abstandsbereichs (S) 1:0,0025 bis 1:1 beträgt; und
wobei ein Verhältnis einer Breite (W2) der Sammelschienenelektrode (24b) zu der Breite (W3) des Abstandsbereichs (S) 1:0,2 bis 1:0,4. beträgt.

3. Solarzelle (150) nach Anspruch 1, ferner umfassend ein Band (142), das mit der Sammelschienenelektrode (24b) verbunden ist,
wobei eine Breite (W7) des Bandes (142) gleich oder kleiner als eine Breite der Sammelschienenelektrode (24b) ist, und
die Breite (W7) des Bandes (142) gleich oder grösser als eine Breite (W4) der Hauptsammelschiene (241b) ist.

4. Solarzelle (150) nach Anspruch 3, wobei ein Verhältnis der Breite (W7) des Bandes (142) zur Breite (W2) der Sammelschienenelektrode (24b) 1:1 bis 1:3 beträgt.

5. Solarzelle (150) nach Anspruch 1, wobei mindestens eines der folgenden Merkmale erfüllt ist:
wobei die erste Elektrode (24) der ersten und zweiten Elektroden (24, 34) die Mehrzahl von Fingerelektroden umfasst (24a) und die Sammelschienenelektrode (24b) die Hauptsammelschiene (341b) und die Hilfssammelschiene (342b) umfasst und wobei die erste Elektrode (24) eine Frontelektrode ist, die auf einer Vorderseite der Solarzelle (150) angeordnet ist; und
wobei die erste Elektrode (24) der ersten und zweiten Elektroden (24, 34) die Mehrzahl von Fingerelektroden (24a) umfasst und die Sammelschienenelektrode (24b) die Hauptsammelschiene (341b) und die Hilfssammelschiene (342b) umfasst, wobei der photoelektrische Umwandlungsabschnitt (110, 20, 30) ein Halbleitersubstrat (110) umfassend einen Basisbereich (10) und einen auf dem Halbleitersubstrat (110) ausgebildeten Emitterbereich (20) umfasst, wobei der Basisbereich (10) ein p-Typ ist und der Emitterbereich (20) ein n-Typ ist, und die erste Elektrode (24) mit dem Emitterbereich (20) verbunden ist.

6. Solarzelle (150) nach Anspruch 5, ferner umfassend ein mit der zweiten Elektrode (34) verbundenes Band (142),
wobei die zweite Elektrode (34) umfasst:
einen in einem Bereich, in dem das Band (142) verbunden ist, ausgebildeten Pad-Abschnitt (34b); und
einen Elektrodenabschnitt (34a), der vollständig über einem Bereich ausgebildet ist, der den Pad-Abschnitt (34b) ausschließt.

7. Solarzelle (150) nach Anspruch 1, wobei mindestens eines der folgenden Merkmale erfüllt ist:
wobei die Sammelschienenelektrode (24b) ferner mindestens einen Brückenelektrodenabschnitt (240c) umfasst, zum Verbinden der Mehrzahl von Hauptelektrodenabschnitten (240b) in einer Richtung, die eine Längsrichtung der Mehrzahl von Hauptelektrodenabschnitten (240b) kreuzt;
wobei die zweite Elektrode (34) der ersten und zweiten Elektroden (24, 34) die Mehrzahl von Fingerelektroden (34a) und die Sammelschienenelektrode (34b) umfassend die Hauptsammelschiene (341b) und die Hilfssammelschiene (342b) umfasst, und die zweite Elektrode (34) eine Rückelektrode ist, die auf einer Rückseite der Solarzelle (150) angeordnet ist; und
wobei die zweite Elektrode (34) der ersten und zweiten Elektroden (24, 34) die mehreren Fingerelektroden (34a) und die Sammelschienenelektrode (34b) umfassend die Hauptsammelschiene (341b) und die Hilfssammelschiene (342b) umfasst, wobei der photoelektrische Umwandlungsabschnitt (110, 20, 30) ein Halbleitersubstrat (110), einen Emitterbereich (20) und einen auf dem Halbleitersubstrat (110) ausgebildeten hinteren elektrischen Feldbereich (30) umfasst, wobei der hintere elektrische Feldbereich (30) ein n-Typ ist und der Emitterbereich (110) ein p-Typ ist, und die zweite Elektrode (34) mit dem hinteren elektrischen Feldbereich (30) verbunden ist.

## Revendications

1. Cellule solaire (150) comprenant :
une partie de conversion photoélectrique (110, 20, 30) ; et
des première et seconde électrodes (24, 34) connectées à la partie de conversion photoélectrique (110, 20, 30),
dans laquelle au moins l'une des première et seconde électrodes (24, 34) comprend :
une pluralité d'électrodes en forme de doigt (24a) ; et
au moins une électrode de barre omnibus (24b) formée dans une direction croisant les électrodes en forme de doigt (24a),
dans laquelle l'électrode de barre omnibus (24b) comprend :
une barre omnibus principale (341b) ; et
une barre omnibus auxiliaire (342b) formée de manière adjacente à la barre omnibus principale (341b) de telle sorte que la barre omnibus auxiliaire (342b) est espacée de la barre omnibus principale (341b) par une zone d'espacement (S),
dans laquelle la zone d'espacement (S) a une largeur (W3) inférieure à un pas (P1) de la pluralité d'électrodes en forme de doigt (24a),
**caractérisée en ce qu'**un rapport d'une largeur (W1) de la pluralité d'électrodes en forme de doigt (24a) à une largeur (W6) de la barre omnibus auxiliaire (342b) est compris entre 1:1 et 1:1,5, et **en ce que** la barre omnibus principale (341b) comprend une pluralité de parties d'électrode principale (343b, 344b) et une pluralité d'ouvertures (340a) disposées dans le sens de la largeur de la barre omnibus principale (341b) et la pluralité de parties d'électrode principale (343b, 344b) sont disposées de telle sorte que la pluralité d'ouvertures (340a) sont interposées entre elles,
dans laquelle la pluralité de parties d'électrode principale (343b, 344b) comprend :
des premières parties d'électrode principale (343b) disposées des deux côtés de la barre omnibus principale (341b) ; et
une seconde partie d'électrode principale (344b) disposée entre les premières parties d'électrode principale (343b), et
dans laquelle au moins une largeur (W11) et une épaisseur (H1) de la première partie d'électrode principale (343b) sont différentes de celles (W12, H2) de la seconde partie d'électrode principale (344b).

2. Cellule solaire (150) selon la revendication 1, dans laquelle au moins l'un des éléments suivants est rempli :
dans laquelle un rapport du pas (P1) de la pluralité d'électrodes en forme de doigt (24a) à la largeur (W3) de la zone d'espacement (S) est compris entre 1:0,0025 et 1:1 ; et
dans laquelle un rapport d'une largeur (W2) de l'électrode de barre omnibus (24b) à la largeur (W3) de la zone d'espacement (S) est compris entre 1:0,2 et 1:0,4.

3. Cellule solaire (150) selon la revendication 1, comprenant en outre un ruban (142) connecté à l'électrode de barre omnibus (24b),
dans laquelle une largeur (W7) du ruban (142) est inférieure ou égale à une largeur de l'électrode de barre omnibus (24b), et
la largeur (W7) du ruban (142) est supérieure ou égale à une largeur (W4) de la barre omnibus principale (241b).

4. Cellule solaire (150) selon la revendication 3, dans laquelle un rapport de la largeur (W7) du ruban (142) à la largeur (W2) de l'électrode de barre omnibus (24b) est compris entre 1: 1 et 1:3.

5. Cellule solaire (150) selon la revendication 1, dans laquelle au moins l'un des éléments suivants est rempli :
dans laquelle la première électrode (24) des première et seconde électrodes (24, 34) comprend la pluralité d'électrodes en forme de doigt (24a) et l'électrode de barre omnibus (24b) comprend la barre omnibus principale (341b) et la barre omnibus auxiliaire (342b), et la première électrode (24) est une électrode avant disposée sur une surface avant de la cellule solaire (150) ; et
dans laquelle la première électrode (24) des première et seconde électrodes (24, 34) comprend la pluralité d'électrodes en forme de doigt (24a) et l'électrode de barre omnibus (24b) comprend la barre omnibus principale (341b) et la barre omnibus auxiliaire (342b), la partie de conversion photoélectrique (110, 20, 30) comprend un substrat semi-conducteur (110) comprenant une région de base (10) et une région d'émetteur (20) formées sur le substrat semi-conducteur (110), la région de base (10) est de type p et la région d'émetteur (20) est de type n, et la première électrode (24) est connectée à la région d'émetteur (20).

6. Cellule solaire (150) selon la revendication 5, comprenant en outre un ruban (142) connecté à la seconde électrode (34),
dans laquelle la seconde électrode (34) comprend :
une partie plot (34b) formée dans une région dans laquelle le ruban (142) est connecté ; et
une partie électrode (34a) entièrement formée sur une région excluant la partie plot (34b).

7. Cellule solaire (150) selon la revendication 1, dans laquelle au moins l'un des éléments suivants est rempli :
dans laquelle l'électrode de barre omnibus (24b) comprend en outre au moins une partie d'électrode en pont (240c) pour connecter la pluralité de parties d'électrode principale (240b) dans une direction croisant une direction longitudinale de la pluralité de parties d'électrode principale (240b) ;
dans laquelle la seconde électrode (34) des première et seconde électrodes (24, 34) comprend la pluralité d'électrodes en forme de doigt (34a) et l'électrode de barre omnibus (34b) comprenant la barre omnibus principale (341b) et la barre omnibus auxiliaire (342b), et la seconde électrode (34) est une électrode arrière disposée sur une surface arrière de la cellule solaire (150) ; et
dans laquelle la seconde électrode (34) des première et seconde électrodes (24, 34) comprend la pluralité d'électrodes en forme de doigt (34a) et l'électrode de barre omnibus (34b) comprenant la barre omnibus principale (341b) et la barre omnibus auxiliaire (342b), la partie de conversion photoélectrique (110, 20, 30) comprend un substrat semi-conducteur (110) et une région d'émetteur (20) et une région de champ électrique arrière (30) formées sur le substrat semi-conducteur (110), la région de champ électrique arrière (30) est de type n et la région d'émetteur (20) est de type p, et la seconde électrode (34) est connectée à la région de champ électrique arrière (30).
